# EUROPÄISCHE PATENTANMELDUNG

(11) **EP 2 395 379 A2**
(43) Veröffentlichungstag der Anmeldung: **14.12.2011**
(21) Anmeldenummer: 11167504.7
(22) Anmeldetag: 25.05.2011
(51) Int. Cl.: G02B 6/44, H05K 7/14

(54) **Vorrichtung zur Handhabung von Datenleitern**

(30) Priorität: 09.06.2010 DE 202010007778 U
(71) Anmelder: CCS Technology, Inc., Wilmington, DE 19803 (US)
(72) Erfinder: Ciechomski, Tomasz, 99-400, Lowicz (PL); Fabrykowski, Grzegorz, 95-010, Strykow (PL)
(74) Vertreter: Sturm, Christoph

(57) **Zusammenfassung**

Vorrichtung zur Handhabung von Datenleitern, insbesondere von Lichtwellenleitern, bzw. von Verbindungsstellen zwischen Datenleitern, mit einem Gehäuse (11) und einer in dem Gehäuse (11) gelagerten, schubladenartigen Aufnahme (12), wobei die Aufnahme (12) Baugruppen zum Verbinden und/oder Ablegen von Datenleitern aufnimmt, wobei die schubladenartige Aufnahme (12) für einen erleichterten Zugriff auf die Baugruppen, die dem Verbinden und/oder Ablegen der Datenleiter dienen, zumindest teilweise aus dem Gehäuse (11) translatorisch heraus bewegbar ist, und wobei die schubladenartige Aufnahme (12) in mindestens einer translatorischen Relativposition zum Gehäuse (11) gegenüber dem Gehäuse (11) schwenkbar ist. (Fig. 2)

## Beschreibung

Die vorliegende Erfindung betrifft eine Vorrichtung zur Handhabung von Datenleitern, insbesondere von Lichtwellenleitern, bzw. von Verbindungsstellen zwischen Datenleitern gemäß dem Oberbegriff des Anspruchs 1.

Beim Aufbau von zum Beispiel Lichtwellenleiterkabel-Netzwerken werden Vorrichtungen zur Handhabung von Lichtwellenleitern bzw. von Verbindungsstellen zwischen Lichtwellenleitern für die Gewährleistung einer strukturierten Verkabelung benötigt. Eine Anforderung, die an solche Vorrichtungen gestellt wird, ist eine maximale Bestückung derselben bei hoher Packungsdichte und gleichzeitiger geringfügiger mechanischer Beanspruchung der Lichtwellenleiter. Weiterhin müssen die in solchen Vorrichtungen abgelegten Lichtwellenleiter bzw. Verbindungsstellen zwischen Lichtwellenleitern gut zugänglich sein, um zum Beispiel Spleißarbeiten oder Rangierarbeiten sicher ausführen zu können. Ähnliche Anforderungen bestehen auch beim Aufbau von Netzwerken aus Kupferleitern oder anderen Datenleitern.

Um die oben genannten Anforderungen zu erfüllen, ist es aus dem Produktkatalog "Zubehör für LWL-Kabelnetze, Seiten 180-181, Ausgabe 1, Corning Cable Systems GmbH & Co KG, Jahr 2001" bereits bekannt, bei einer Vorrichtung zur Handhabung von Lichtwellenleitern mehrere Baugruppen, zum Beispiel Steckverbinder oder Spleiβkassetten, auf einer gemeinsamen schubladenartigen Aufnahme anzuordnen, die von einem Gehäuse umgeben ist. Die auf der schubladenartigen Aufnahme positionierten Baugruppen sind zusammen mit der Aufnahme zumindest teilweise aus dem Gehäuse heraus bewegbar, nämlich durch translatorisches Herausziehen der Aufnahme aus dem Gehäuse. Durch das translatorische Herausziehen der schubladenartigen Aufnahme aus dem Gehäuse ist bereits ein erleichterter Zugriff auf die auf der schubladenartige Aufnahme positionierten Baugruppen zur Handhabung der als Lichtwellenleiter ausgeführten Datenleiter bzw. der Verbindungsstellen zwischen den Lichtwellenleitern bzw. Datenleitern möglich, es besteht jedoch Bedarf daran, diesen Zugriff weiter zu verbessern.

Hiervon ausgehend liegt der vorliegenden Erfindung das Problem zu Grunde, eine neuartige Vorrichtung zur Handhabung von Datenleitern bzw. von Verbindungsstellen zwischen Datenleitern mit einer verbesserten Zugänglichkeit der handzuhabenden Datenleiter bzw. der Verbindungsstellen zwischen den Datenleitern zu schaffen. Dieses Problem wird durch eine Vorrichtung mit den Merkmalen des Anspruchs 1 gelöst. Erfindungsgemäß ist die schubladenartige Aufnahme in mindestens einer translatorischen Relativposition zum Gehäuse gegenüber dem Gehäuse schwenkbar.

Erfindungsgemäß ist die schubladenartige Aufnahme in mindestens einer translatorischen Relativposition der Aufnahme zum Gehäuse gegenüber dem Gehäuse schwenkbar. Hierdurch wird ein Zugriff auf in der Aufnahme positionierte Baugruppen zum Handhaben der Datenleiter bzw. der Verbindungsstellen zwischen den Datenleitern weiter erleichtert. Ferner wird eine mechanische Beanspruchung der Datenleiter nicht erhöht.

Nach einer bevorzugten Weiterbildung der Erfindung umfasst das Gehäuse zwei gegenüberliegende Seitenwände und die schubladenartige Aufnahme umfasst zwei gegenüberliegende Seitenwände. In beide der sich gegenüberliegenden Seitenwände des Gehäuses ist jeweils ein Führungsschlitz eingebracht. In jeden der Führungsschlitze greifen zwei einer jeweils benachbarten Seitenwand der Aufnahme zugeordnete Führungsstifte ein, wobei die Führungsstifte beim translatorischen Verlagern der schubladenartigen Aufnahme relativ zum Gehäuse im jeweiligen Führungsschlitz des Gehäuses geführt sind.

Beide Führungsschlitze weisen an dergleichen Axialposition bzw. Längserstreckungsposition jeweils eine sich quer zur Längserstreckung des Führungsschlitzes erstreckende, nach oben gerichtete, kreisbogenförmige Abzweigung auf. Beim schwenkartigen Verlagern der schubladenartigen Aufnahme relativ zum Gehäuse ist in jeder der Abzweigungen ein in Auszugrichtung der schubladenartigen Aufnahme hinterer Führungsstift der jeweiligen Seitenwand der Aufnahme geführt, sodass ein vorderer Abschnitt der Aufnahme relativ zum Gehäuse nach unten schwenkbar ist.

Bevorzugte Weiterbildungen der Erfindung ergeben sich aus den Unteransprüchen und der nachfolgenden Beschreibung. Ein Ausführungsbeispiel wird anhand der Zeichnung näher erläutert. In der Zeichnung zeigt:
- Fig. 1:: eine erfindungsgemäße Vorrichtung zur Handhabung von Datenleitern bzw. von Verbindungsstellen zwischen Datenleitern in Seitenansicht mit einer ins Gehäuse eingefahrenen Aufnahme;
- Fig. 2:: die erfindungsgemäße Vorrichtung gemäß Fig. 1 mit einer aus dem Gehäuse ausgefahrenen und gegenüber dem Gehäuse verschwenkten Aufnahme; und
- Fig. 3:: einen Ausschnitt aus Fig. 2 in perspektivischer Ansicht.

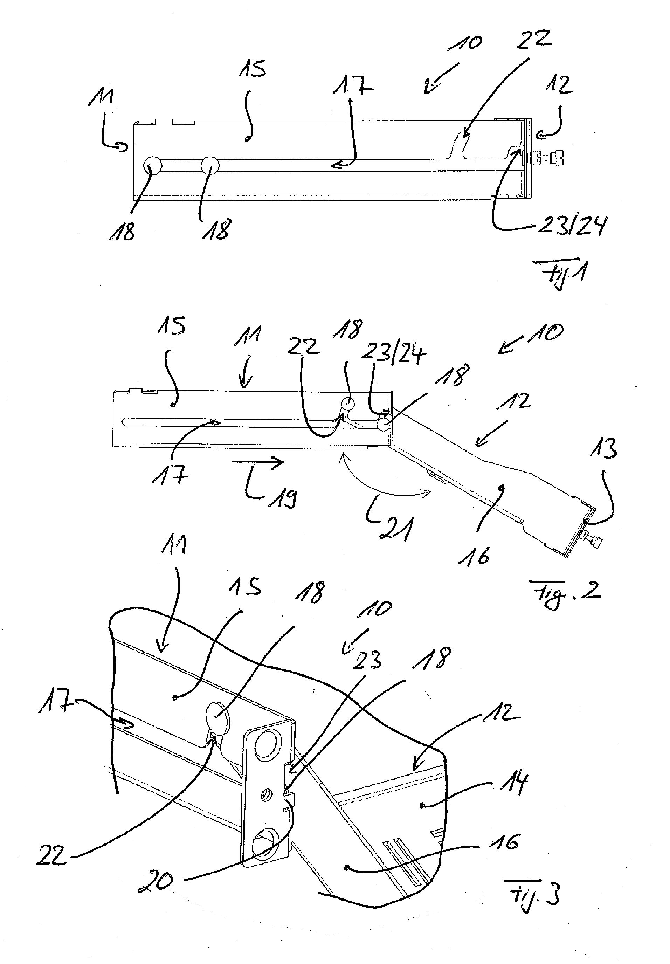

Fig. 1 bis 3 zeigen unterschiedliche Ansichten einer erfindungsgemäßen Vorrichtung 10 zur Handhabung von Datenleitern bzw. von Verbindungsstellen zwischen Datenleitern. Die in Fig. 1 bis 3 gezeigte Vorrichtung 10 kann zum Beispiel in einem Verteilerschrank oder Verteilergestell verbaut sein uns dient insbesondere der Handhabung von Lichtwellenleitern.

Die erfindungsgemäße Vorrichtung 10 verfügt über ein Gehäuse 11 und eine in dem Gehäuse 11 gelagerte, schubladenartige Aufnahme 12. Auf der Aufnahme 12 sind nicht gezeigte Baugruppen zum Verbinden und/oder Ablegen von insbesondere als Lichtwellenleiter ausgebildeten Datenleitern positioniert.

So kann eine Vorderwand 13 der Aufnahme 12 Steckverbinder tragen, um ein Patchfeld für zum Beispiel Lichtwellenleiter bereitzustellen. Auf einer Bodenwand 14 der schubladenartigen Aufnahme 12 können Spleißkassetten und/oder Überlängenspeicher für zum Beispiel Lichtwellenleiter positioniert sein.

Die schubladenartige Aufnahme 12 ist für einen erleichterten Zugriff auf die von der Aufnahme 12 aufgenommenen Baugruppen, die dem Verbinden und/oder Ablegen von Datenleitern dienen, zumindest teilweise aus dem Gehäuse 11 translatorisch heraus bewegbar und weiterhin erfindungsgemäß in mindestens einer translatorischen Relativposition zum Gehäuse 11 gegenüber dem Gehäuse 11 schwenkbar. So zeigt Fig. 2 die Aufnahme 12 in einer aus dem Gehäuse 11 translatorisch herausbewegten und gegenüber dem Gehäuse 11 nach unten geschwenkten Relativposition. In Fig. 1 ist die schubladenartige Aufnahme 12 vollständig in das Gehäuse 11 eingeschoben.

Das Gehäuse 11 der erfindungsgemäßen Vorrichtung 10 verfügt über zwei sich gegenüberliegende Seitenwände 15. Ebenso verfügt die schubladenartige Aufnahme 12 der erfindungsgemäßen Vorrichtung 10 über zwei sich gegenüberliegende Seitenwände 16.

In mindestens eine der sich gegenüberliegenden Seitenwände 15 des Gehäuses 11, nämlich im gezeigten Ausführungsbeispiel in beide sich gegenüberliegende Seitenwände 15 des Gehäuses 11, ist jeweils ein Führungsschlitz 17 eingebracht.

In jeden Führungsschlitz 17 greifen Führungsstifte 18 ein, die der zum jeweiligen Führungsschlitz 17 benachbarten Seitenwand 16 der Aufnahme 12 zugeordnet sind. Die Führungsstifte 18 sind beim translatorischen Verlagern der schubladenartigen Aufnahme 12 relativ zum Gehäuse 11 in dem jeweiligen Führungsschlitz 17 des Gehäuses 11 geführt.

Im gezeigten Ausführungsbeispiel sind jeder Seitenwand 16 der schubladenartigen Aufnahme 12 jeweils zwei Führungsstifte 18 zugeordnet. Die jeder Seitenwand 16 der Aufnahme 12 zugeordneten Führungsstifte 18 greifen in die benachbarten Führungsschlitze 17 der jeweils benachbarten Seitenwand 15 des Gehäuses 11 ein.

Dann, wenn wie Fig. 1 zeigt, die schubladenartige Aufnahme 12 vollständig in das Gehäuse 11 hinbewegt ist, liegt ein in Auszugrichtung 19 hinterer Führungsstift 18 an einer seitlichen Begrenzung des Führungsschlitzes 17 an.

Dann, wenn die schubladenartige Aufnahme 12 gemäß Fig. 2 maximal aus dem Gehäuse 11 herausgezogen ist, liegt ein in Auszugrichtung 19 der schubladenartigen Aufnahme 12 vorderer Führungsstift 18 an einem Anschlag 20 an, der von der Seitenwand 15 des Gehäuses 11 bereitgestellt wird und das Herausziehen der schubladenartige Aufnahme 12 aus dem Gehäuse 11 beschränkt.

Um nicht nur ein translatorisches Herausziehen der schubladenartigen Aufnahme 12 aus dem Gehäuse 11 in Richtung der Auszugrichtung 19 zu ermöglichen, sondern vielmehr ein Schwenken der schubladenartigen Aufnahme 12 gegenüber dem Gehäuse 11 im Sinne des Doppelpfeils 21 in mindestens einer translatorischen Relativposition zwischen dem Gehäuse 11 und der Aufnahme 12 zu ermöglichen, weist der Führungsschlitz 17 jeder Seitenwand 15 des Gehäuses 11 an mindestens einer Position eine sich quer zur Längsrichtung des Führungsschlitzes 17 erstreckende Abzweigung auf. Diese Abzweigungen 22 sind dabei nach oben gerichtet und kreisbogenförmig konturiert.

Wie bereits ausgeführt, liegen dann, wenn die schubladenartige Aufnahme 12 maximal aus dem Gehäuse 11 in Auszugrichtung 19 translatorisch herausgezogen ist, die in Auszugrichtung 19 vorderen Führungsstifte 18 der Seitenwände 16 der Aufnahme 12 in den Anschlägen 20 der Seitenwände 15 des Gehäuses 11 an. Die Anschläge 20 begrenzen die Führungsschlitze 17 in Auszugrichtung 19 der Aufnahme 12.

In dieser translatorischen Relativposition ist die schubladenartige Aufnahme 12 relativ zum Gehäuse 11 gemäß Fig. 2 nach unten schwenkbar, und zwar vorzugsweise um in etwa 30°.

Hierzu entspricht ein Abstand zwischen den Anschlägen 20 der Seitenwände 15 des Gehäuses 11 und den Abzweigungen 22 von den Führungsschlitzen 17 der Seitenwände 15 des Gehäuses 11 dem Abstand zwischen den in Auszugrichtung 19 vorderen Führungsstiften 18 und den in Auszugrichtung 19 hinteren Führungsstiften 18 der Seitenwände 16 der schubladenartigen Aufnahme 12. Hierdurch ist gewährleistet, dass dann, wenn die schubladenartige Aufnahme 12 maximal aus dem Gehäuse 11 herausgezogen ist, die in Auszugrichtung hinteren Führungsstifte 18 aus dem jeweiligen Führungsschlitz 17 heraustreten und in die jeweiligen Abzweigung 22 des Führungsschlitzes 17 eintreten können, um so die schubladenartige Aufnahme 12 gegenüber dem Gehäuse 11 in der maximal aus dem Gehäuse 11 herausgezogenen translatorischen Relativposition zusätzlich nach unten zu schwenken.

Der Schwenkwinkel zwischen der Aufnahme 12 und dem Gehäuse 11 wird dabei einerseits vom axialen Abstand zwischen den Führungsstiften 18 und andererseits von der Länge der Abzweigungen 22 von den Führungsschlitzen 17 besti m mt.

Wie am besten Fig. 3 entnommen werden kann, sind oberhalb der Anschläge 20 in das Gehäuse 11 im Bereich der Seitenwände 15 des Gehäuses 11 Ausnehmungen 23 eingebracht. Diese Ausnehmungen 23 sind mit dem jeweiligen Führungsschlitz 17 der jeweiligen Seitewand 15 des Gehäuses 11 über eine dem jeweiligen Anschlag 20 benachbarte Aufdickung bzw. Aufweitung 24 des Führungsschlitz 17 gekoppelt und weisen eine an die Führungsstifte 18 angepasste Abmessung auf.

Nach teilweisem Herausziehen der Aufnahme 12 in eine Position, in welcher die in Auszugrichtung 19 vorderen Führungsstifte 18 an den Anschlägen 20 zur Anlage kommen, kann die Aufnahme 12 durch einfaches Anheben derselben über die Ausnehmungen 23 aus dem Gehäuse 11 vollständig heraus bewegt werden.

Ebenso kann über die Ausnehmungen 23 eine Aufnahme 12 in das Gehäuse 11, nämlich in die Führungsschlitze 17 derselben, eingefädelt werden. Dies erlaubt einen einfachen und schnellen Austausch einer Aufnahme 12.

### Bezugszeichenliste

- 10: Vorrichtung
- 11: Gehäuse
- 12: Aufnehme
- 13: Vorderwand
- 14: Bodenwand
- 15: Seitenwand
- 16: Seitenwand
- 17: Führungsschlitz
- 18: Führungsstift
- 19: Auszugrichtung
- 20: Anschlag
- 21: Schwenkrichtung
- 22: Abzweigung
- 23: Ausnehmung
- 24: Aufweitung

## Patentansprüche

1. Vorrichtung zur Handhabung von Datenleitern, insbesondere von Lichtwellenleitern, bzw. von Verbindungsstellen zwischen Datenleitern, mit einem Gehäuse (11) und einer in dem Gehäuse (11) gelagerten, schubladenartigen Aufnahme (12), wobei die Aufnahme (12) Baugruppen zum Verbinden und/oder Ablegen von Datenleitern aufnimmt, und wobei die schubladenartige Aufnahme (12) für einen erleichterten Zugriff auf die Baugruppen, die dem Verbinden und/oder Ablegen der Datenleiter dienen, zumindest teilweise aus dem Gehäuse (11) translatorisch heraus bewegbar ist, **dadurch gekennzeichnet, dass** die schubladenartige Aufnahme (12) in mindestens einer translatorischen Relativposition zum Gehäuse (11) gegenüber dem Gehäuse (11) schwenkbar ist.

2. Vorrichtung nach Anspruch 1, **dadurch gekennzeichnet, dass** das Gehäuse (11) zwei gegenüberliegende Seitenwände (15) aufweist, und dass die schubladenartige Aufnahme (12) zwei gegenüberliegende Seitenwände (16) aufweist, wobei in mindestens eine der sich gegenüberliegenden Seitenwände (15) des Gehäuses (11) ein Führungsschlitz (17) eingebracht ist, in den einer benachbarten Seitenwand (16) der Aufnahme (12) zugeordnete Führungsstifte (18) eingreifen, wobei die Führungsstifte (18) beim translatorischen Verlagern der schubladenartigen Aufnahme (12) relativ zum Gehäuse (11) im jeweiligen Führungsschlitz (17) des Gehäuses (11) geführt sind.

3. Vorrichtung nach Anspruch 2, **dadurch gekennzeichnet, dass** der oder jeder Führungsschlitz (17) an mindestens einer Position desselben eine sich quer zur Längserstreckung des Führungsschlitzes (17) erstreckende Abzweigung (22) aufweist, in welcher ein Führungsstift (18) beim schwenkartigen Verlagern der schubladenartigen Aufnahme (12) relativ zum Gehäuse (11) geführt ist.

4. Vorrichtung nach Anspruch 2 oder 3, **dadurch gekennzeichnet, dass** das Gehäuse (11) an beiden gegenüberliegenden Seitenwänden (15) jeweils einen Führungsschlitz (17) aufweist, und dass die schubladenartige Aufnahme (12) an beiden gegenüberliegenden Seitenwänden (16) jeweils zwei voneinander beabstandete, in die Führungsschlitze (17) eingreifende Führungsstifte (18) aufweist, wobei beide Führungsschlitze (17) an dergleichen Position derselben jeweils eine sich quer zur Längserstreckung des Führungsschlitzes (17) erstreckende Abzweigung (22) aufweisen, in der jeweils einer der beiden Führungsstifte (18) beim schwenkartigen Verlagern der schubladenartigen Aufnahme (12) relativ zum Gehäuse (11) geführt ist.

5. Vorrichtung nach einem der Ansprüche 2 bis 4, **dadurch gekennzeichnet, dass** ein in Auszugrichtung der schubladenartigen Aufnahme (12) vorderer Führungsstift (18) der jeweiligen Seitenwand (16) der Aufnahme (12) beim Herausziehen der schubladenartigen Aufnahme (12) aus dem Gehäuse (11) an einem Anschlag (20) des Gehäuses (11) zur Anlage kommt und so das Herausziehen der Aufnahme (12) aus dem Gehäuse (11) beschränkt, wobei an der Position der jeweiligen Seitenwand (15) des Gehäuses, die einen Abstand zum jeweiligen Anschlag (20) aufweist, der dem Abstand des in Auszugrichtung der Aufnahme (12) vorderen Führungsstifts (18) zu einem in Auszugrichtung der Aufnahme (12) hinteren Führungsstift (18) der jeweiligen Seitenwand (16) der Aufnahme entspricht, der jeweilige Führungsschlitz (17) der jeweiligen Seitenwand des Gehäuses eine nach oben gerichtete Abzweigung (22) aufweist, in die dann, wenn der oder jeder in Auszugrichtung der schubladenartigen Aufnahme (12) vordere Führungsstift (18) am Anschlag (20) anliegt, beim Verschwenken der Aufnahme (12) relativ zum Gehäuse (11) der jeweilige in Auszugrichtung der Aufnahme (12) hintere Führungsstift (18) der jeweiligen Seitenwand (16) der Aufnahme (12) eingreift, sodass ein vorderer Abschnitt der Aufnahme (12) relativ zum Gehäuse (11) nach unten schwenkbar ist.

6. Vorrichtung nach Anspruch 5, **dadurch gekennzeichnet, dass** die Ersteckung der oder jeder Abzweigung (22) des oder jedes Führungsschlitzes (17) und/oder der Abstand zwischen dem oder jedem in Auszugrichtung der schubladenartigen Aufnahme (12) vorderen Führungsstift (18) und dem jeweiligen in Auszugrichtung der schubladenartigen Aufnahme (12) hinteren Führungsstift (18) derart bemessen ist, dass die Aufnahme (12) relativ zum Gehäuse (11) um in etwa 30° nach unten schwenkbar ist.

7. Vorrichtung nach Anspruch 5 oder 6, **dadurch gekennzeichnet, dass** oberhalb des jeweiligen Anschlags (20) in das Gehäuse (11) im Bereich der jeweiligen Seitewand (15) des Gehäuses (11) jeweils eine Ausnehmung (23) eingebracht ist, die mit dem jeweiligen Führungsschlitz (17) gekoppelt ist und eine an die Führungsstifte (18) angepasste Abmessung aufweist, sodass nach Anheben der Aufnahme (12) dieselbe über die Ausnehmungen (23) aus dem Gehäuse (11) vollständig heraus bewegbar ist.

8. Vorrichtung nach einem der Ansprüche 3 bis 6, **dadurch gekennzeichnet, dass** die Abzweigung (22) des oder jedes Führungsschlitzes (17) kreisbogenförmig konturiert ist.
